# EUROPEAN PATENT SPECIFICATION

(11) **EP 3 680 295 B1**
(45) Date of publication and mention of the grant of the patent: **03.01.2024**
(21) Application number: 18854105.6
(22) Date of filing: 27.08.2018
(51) Int. Cl.: C08L 101/00, C08K 3/38, H01L 23/36, H01L 23/373, H05K 7/20, C08L 83/04

(54) **THERMALLY CONDUCTIVE SHEET**
WÄRMELEITENDE FOLIE
FEUILLE THERMOCONDUCTRICE

(30) Priority: 06.09.2017 JP 2017171087
(43) Date of publication of application: 15.07.2020
(73) Proprietor: Denka Company Limited, Tokyo 103-8338 (JP)
(72) Inventor: YAMAGATA,Toshitaka, Omuta-city Fukuoka 836-8510 (JP); WADA,Kosuke, Omuta-city Fukuoka 836-8510 (JP); KANEKO,Masahide, Omuta-city Fukuoka 836-8510 (JP)
(74) Representative: Gulde & Partner
(86) International application number: PCT/JP2018/031599
(87) International publication number: WO 2019/049707

(56) References cited:
- WO-A1-2014/136959
- JP-A- 2010 157 563
- JP-A- 2011 098 882
- JP-A- 2011 178 961
- JP-A- 2014 162 697
- JP-A- 2016 027 142
- JP-A- 2017 028 128
- JP-A- 2017 082 091

## Description

### Technical Field

The present invention relates to a sheet having excellent thermal conductivity, and applications of the sheet, and particularly relates to a thermally conductive sheet allowed to be incorporated in an electron device without any damage of heat-releasing electronic components such as power devices, transistors, thyristors and CPUs (Central Processing Unit) when the thermally conductive sheet is used as a heat-dissipating member for electronic components.

### Background Art

In heat-releasing electronic components such as power devices, transistors, thyristors and CPUs, a matter of importance is how to remove heat generated during the operation of the electronic components. In a conventional manner, as such a heat-removal method, heat is typically released by attaching the heat-releasing electronic component to heat-dissipating fins or a metallic plate through a thermally conductive sheet having electrical insulation properties, and the thermally conductive sheet is obtained by dispersing a thermally conductive filler in a silicone rubber.

In recent years, with a higher degree of integration of a circuit in an electronic component, the amount of heat generated in the circuit has become larger, and a material having higher thermal conductivity than conventionally has been demanded. Up to now, for the purpose of improving the thermal conductivity of the thermally conductive material, it has been typical to incorporate a filler exhibiting high thermal conductivity such as an aluminum oxide powder, a boron nitride powder and an aluminum nitride powder in an organic resin. Also, hexagonal boron nitride powder in the form of scale having poor loading ability has been subjected to a method by which the hexagonal boron nitride powder as secondary agglomerated particles is loaded into an organic resin to provide high thermal conductivity (Patent Literatures 1 to 4). The orientation of the hexagonal boron nitride powder is described in Patent Literatures 5 and 6, or the like. Patent Literatures 9, 10 and 11 disclose further thermally conductive sheets.

### Citation List

### Patent Literature

Patent Literature 1: Japanese Patent Laid-Open No. 11-60216
Patent Literature 2: Japanese Patent Laid-Open No. 2003-60134
Patent Literature 3: Japanese Patent Laid-Open No. 2008-293911
Patent Literature 4: Japanese Patent Laid-Open No. 2009-24126
Patent Literature 5: Japanese Patent Laid-Open No. 09-202663
Patent Literature 6: Japanese Patent Laid-Open No. 11-26661
Patent Literature 7: Japanese Patent No. 6125273
Patent Literature 8: Japanese Patent No. 5036696
Patent Literature 9: JP 2017 082091 A
Patent Literature 10: JP 2017 028128 A
Patent Literature 11: JP 2016 027142 A

### Summary of Invention

### Technical Problem

However, in conventional technologies, it has been difficult to obtain a sheet-shaped member having excellent thermal conductivity. Highly thermally conductive members employing a BN molded article as in Patent Literature 7 is known; however, these members employing a BN molded article have poor flexibility as a member, and therefore, are not suitable in applications of heat dissipation on a curved surface, and applications under high tightening torque. In addition, it is not possible in a practical viewpoint to reduce the thickness of the member into 300 µm or less. In addition, for example, Patent Literature 8 describes a sheet having high thermal conductivity; however, the porosity of BN agglomerated particles for use in this sheet is 50% or less, and this allows for the thermal conductivity to be merely in the order of 6 W/ (m·K).

### Solution to Problem

It is an object of the present invention to provide a sheet having excellent thermal conductivity. In particular, it is an object of the present invention to provide a thermally conductive sheet suitable as a heat-dissipating member for electronic components.

For the purpose of solving the above problem, embodiments of the present invention may provide the following.

(1) A thermally conductive sheet obtained by dispersing, in a thermosetting resin comprising a silicone resin of addition reaction type, a secondary agglomerated particle obtained by agglomerating primary particles of scale-shaped boron nitride,
   wherein the secondary agglomerated particle has an average particle size of 50 µm or more and 120 µm or less, and a porosity of 51% or more and 60% or less, and a particle strength of the secondary agglomerated particle at a cumulative destruction rate of 63.2% is 0.2 MPa or more and 2.0 MPa or less, and a loading rate of the secondary agglomerated particle in the thermally conductive sheet is 50% by volume or more and 70% by volume or less.
(2) A heat-dissipating member, comprising the thermally conductive sheet according to the above (1).

### Advantageous Effects of Invention

According to an embodiment of the present invention, it is possible to provide a sheet exhibiting high thermal conductivity.

### Description of Embodiments

Hereinbelow, the present invention will be described in detail.

A secondary agglomerated particle obtained by agglomerating primary particles of scale-shaped boron nitride used in an embodiment of the present invention is required to have an average particle size of 50 to 120 µm, and in addition, the average particle size is preferably in the range of 70 to 90 µm. When the average particle size is greater than 120 µm, this leads to the following problem: the gap between particles upon contact with each other is large, and the thermal conductivity decreases, and this also leads to difficulties in obtaining a thin sheet. In contrast to this, when the average particle size is less than 50 µm, this leads to the following problem: the loading ability of the secondary agglomerated particles in the thermosetting resin is impaired, and the thermal conductivity decreases.

In addition, the thermally conductive sheet according to an embodiment of the present invention may further include an electrically conductive powder of aluminum, copper, silver, carbon fibers, carbon nanotubes or the like, as long as the heat dissipation is not impaired.

The secondary agglomerated particle obtained by agglomerating primary particles of scale-shaped boron nitride used in an embodiment of the present invention is required to have a porosity of 51 to 60%, and in addition, the porosity is preferably in the range of 53 to 57%. When the porosity is greater than 60%, the particle strength is low, and this leads to the following problem: a sheet is difficult to obtain. In contrast to this, when the porosity is less than 51%, this leads to the following problem: the loading ability of the thermosetting resin in the secondary agglomerated particle is impaired, and the thermal conductivity decreases. By setting the porosity of the BN agglomerated particle to 51 to 60%, the loading of the BN agglomerated particle into the resin is improved to an extent that cannot be achieved by conventional technologies, and as a result of this, high thermal conductivity may be achieved.

With regard to the secondary agglomerated particles obtained by the agglomeration of primary particles of scale-shaped boron nitride used in an embodiment of the present invention the particle strength at a cumulative destruction rate of 63.2% is 0.2 to 2.0 MPa, and in addition, is preferably in the range of 0.3 to 1.8 MPa, and more preferably in the range of 0.3 to 1.5 MPa. When the particle strength at a cumulative destruction rate of 63.2% is greater than 2.0 MPa, deformation in the secondary agglomerated particle does not occur, and this leads to point-to-point contact instead of surface-to-surface contact, and the thermal conductivity of the thermally conductive sheet decreases. In contrast to this, when the particle strength at a cumulative destruction rate of 63.2% is less than 0.2 MPa, the secondary agglomerated particle tends to be destructed, the anisotropy is to a large extent, and the thermal conductivity of the thermally conductive sheet decreases.

The loading rate of the secondary agglomerated particle in the thermally conductive sheet according to an embodiment of the present invention is 50 to 70% by volume based on the total volume, and in particular, this loading rate is preferably 55 to 65% by volume. When the loading rate of the secondary agglomerated particle is less than 50% by volume, the thermal conductivity of the thermally conductive sheet is unsatisfactory, and when the loading rate of the secondary agglomerated particle is greater than 70% by volume, the thermally conductive filler is difficult to load.

As described above, the secondary agglomerated particle having a specific average particle size, porosity and particle strength in combination, has excellent characteristics in a viewpoint of thermal conductivity, and a viewpoint of physical properties regarding the preparation of the sheet. This specific secondary agglomerated particle is used with a loading rate in the range of 50% by volume or more and 70% by volume or less to prepare a thermally conductive sheet, and as a result of this, very high thermal conductivity that cannot be achieved by conventional technologies may be accomplished.

The average particle size in the present specification is measured by using SALD-200, an apparatus for measuring particle size distribution using laser diffraction, manufactured by Shimadzu Corporation. 50 cc of pure water and 5 g of a thermally conductive powder to be measured, which is a sample for the evaluation, are added to a glass beaker, stirred with a spatula, and subsequently subjected to dispersing treatment for 10 minutes by using an ultrasonic washing machine. A solution of the powder of the thermally conductive material subjected to dispersing treatment is added dropwise into a sampler within the apparatus by using a pipette, and the stabilization of the absorbance is awaited until the absorbance is measurable. When the absorbance is stabilized in this way, the measurement is performed. In an apparatus for measuring particle size distribution using laser diffraction, the particle size distribution is calculated from data of the light intensity distribution regarding the diffraction/scattered light due to the particles detected by a sensor. The average particle size is determined by multiplying the measured value of the particle size by the relative amount of the particles (%difference), and dividing the resulting value by the total relative amount of the particles (100%). The average particle size is the average diameter of the particle.

The porosity of the secondary agglomerated particle obtained by agglomerating primary particles of scale-shaped boron nitride in the present specification means a value obtained by measuring a mercury intrusion porosimeter. The porosity is a value determined by measuring a pore volume by using a mercury porosimeter. The pore volume based on the use of the mercury porosimeter may be determined by using, for example, "PASCAL 140-440" (manufactured by FISONS INSTRUMENTS). The principle of this measurement is based on the expression: εg = Vg/(Vg + 1/pt) × 100. In the expression, εg is the porosity of the boron nitride particle (%), Vg is a value obtained by subtracting the volume of voids between the particles from the pore volume (cm³/g), ρt is the density of the hexagonal boron nitride particle as a primary particle of 2.34 (g/cm³).

In the present specification, the particle strength at a cumulative destruction rate of 63.2% (single-granule crushing strength) regarding the secondary agglomerated particle obtained by agglomerating primary particles of scale-shaped boron nitride may be determined according to JIS R1639-5:2007. The value "63.2%" referred to here is known to be a value satisfying lnln{1/(1 - F(t))} = 0 in the Weibull distribution function, which is taught in JIS R1625:2010 cited by the above JIS R1639-5:2007, and is a value based on the number of the particles.

A millable silicone is not used in the present invention according to the claims. Since the required flexibility is often difficult to achieve, a silicone of addition reaction type is used for the purpose of achieving high flexibility. Specific examples of the liquid silicone of addition reaction type include an organopolysiloxane of one-part reaction type having both of a vinyl group and a H-Si group in a single molecule, or a two-part silicone made of an organopolysiloxane having a vinyl group located at the end or the side chain, and of an organopolysiloxane having two or more H-Si groups located at the end or the side chain. Examples include those under trade name "ERASTOSIL LR3303-20/A/B" manufactured by Wacker Asahikasei Silicone Co., Ltd.

The liquid silicone of addition reaction type allowed for use in an embodiment of the present invention may be used in combination with reaction retarding agents such as acetyl alcohols or maleic acid esters, thickening agents such as Aerosil or a silicone powder having a size of tens to several hundreds of micrometers, flame retardants, pigments, and the like.

If desired, the thickness of the thermally conductive sheet according to an embodiment of the present invention may be reduced into 200 µm to provide the thermally conductive sheet with flexibility, and as a result of this, degree of freedom regarding a method for installing the thermally conductive sheet may be improved.

The thermally conductive sheet according to an embodiment of the present invention may be used in combination with a glass cloth as a reinforcing material. Examples of the glass cloth include gray cloth purely made of woven glass fibers, and cloths subjected to a certain treatment such as one subjected to heat cleaning or treatment with a coupling agent, and for example, mention may be made to those under trade name "H25 F104" manufactured by Unitika Ltd.

In a method for producing a thermally conductive sheet of the present invention, an agglomerated powder of a boron nitride powder is added to a liquid silicone of addition reaction type, and mixed together by using a planetary centrifugal mixer, "Awatori Rentaro" manufactured by Thinky Corporation, and as a result of this, a mixture may be produced without the disintegration of the agglomerated powder of the boron nitride powder.

### Example

For the purpose of evaluating the thermal conductivity of the thermally conductive sheet described below, a sheet-formed article was produced. In the production of the sheet-formed article, a plunger extruder was used to produce the sheet without the disintegration of the agglomerated powder of the boron nitride powder. The samples of the sheet-formed article for the evaluation of thermal conductivity had the respective thickness stated in the following tables, and in addition, had a size of 10 mm × 10 mm.

The thermal conductivity was calculated by multiplying all of the thermal diffusivity, the density and the specific heat of the resin composition according to ASTM E-1461 (thermal conductivity = thermal diffusivity × density × specific heat). The sample was worked into a width of 10 mm × 10 mm × a thickness of 0.5 mm to determine the thermal diffusivity by a laser flash method. As the measurement apparatus, a xenon flash analyzer (LFA447 NanoFlash manufactured by NETSCH) was employed, and the measurement was performed at 25°C. The density was determined according to the Archimedes method. The specific heat was determined by using DSC (ThermoPlus Evo DSC8230 manufactured by Rigaku Corporation).

### (Examples 1 to 7, and Comparative Examples 1 to 6)

By using as a planetary centrifugal mixer, "Awatori Rentaro" manufactured by Thinky Corporation at rotating speed of 2000 rpm, seven agglomerated powders of hexagonal boron nitride shown as thermally conductive powders in Table 1, one ERASTOSIL LR3303-20/A solution (an organopolysiloxane having a vinyl group and containing a platinum catalyst) shown as the liquid silicone of addition reaction type, as recited in the independent claims, in Tables 2 and 3, and one ERASTOSIL LR3303-20/B solution (an organopolysiloxane having a H-Si group, and an organopolysiloxane having a vinyl group) were mixed together according to the formulation (% by volume) shown in Tables 2 and 3 at a room temperature for 10 minutes to produce a mixture.

This mixture in an amount of 100 g was loaded into a cylinder-structured metallic mold to which a die having a slit (any of 0.2 mm × 10 mm, 0.5 mm × 10 mm, and 1 mm × 10 mm), and subsequently, the mixture was extruded from the slit under a pressure of 5 MPa by using a piston to obtain a sheet having a predetermined thickness. This sheet was heated at 110°C for 3 hours to produce a sheet for the evaluation of the thermal conductivity, and the thermal conductivity was measured by the above-described method. The results are shown in Tables 2 and 3.

From Examples in Table 2 and Comparative Examples in Table 3, it can be seen that the thermally conductive sheets according to an embodiment of the present invention exhibit excellent thermal conductivity. In Comparative Examples, there were the following problems: the sheet was difficult to obtain by nature, or the thermal conductivity was low.

**[Table 1]**

| Referential mark of filler | Type | Average particle size (µm) | Porosity (%) | Particle strength (Mpa) |
|---|---|---|---|---|
| Thermally conductive filler A | Agglomerated powder of hexagonal boron nitride | 200 | 65 | 0.1 |
| Thermally conductive filler B | Agglomerated powder of hexagonal boron nitride | 120 | 60 | 0.3 |
| Thermally conductive filler C | Agglomerated powder of hexagonal boron nitride | 80 | 55 | 0.7 |
| Thermally conductive filler D | Agglomerated powder of hexagonal boron nitride | 50 | 51 | 1.8 |
| Thermally conductive filler E | Agglomerated powder of hexagonal boron nitride | 20 | 40 | 3.0 |
| Thermally conductive filler F | Agglomerated powder of hexagonal boron nitride | 55 | 45 | 2.5 |
| Thermally conductive filler G | Agglomerated powder of hexagonal boron nitride | 60 | 25 | 2.6 |

**[Table 2]**

| | Example 1 | Example 2 | Example 3 | Example 4 | Example 5 | Example 6 | Example 7 |
|---|---|---|---|---|---|---|---|
| Type of boron nitride powder | B | C | D | C | C | C | C |
| Loading rate of boron nitride powder (% by volume) | 60 | 60 | 60 | 70 | 50 | 60 | 60 |
| Amount of silicone resin ELASTOSIL LR3303/20A blended (% by volume) | 20 | 20 | 20 | 15 | 25 | 20 | 20 |
| Amount of silicone resin ELASTOSIL LR3303/20B blended (% by volume) | 20 | 20 | 20 | 15 | 25 | 20 | 20 |
| Thermal conductivity (W/(m-K)) | 8.2 | 8.5 | 8.2 | 8.2 | 8.0 | 8.5 | 8.5 |
| Thickness (mm) | 0.5 | 0.5 | 0.5 | 0.5 | 0.5 | 0.2 | 1.0 |

**[Table 3]**

| | Comparative Example 1 | Comparative Example 2 | Comparative Example 3 | Comparative Example 4 | Comparative Example 5 | Comparative Example 6 |
|---|---|---|---|---|---|---|
| Type of boron nitride powder | A | E | C | C | F | G |
| Loading rate of boron nitride powder (% by volume) | 60 | 60 | 10 | 80 | 60 | 70 |
| Amount of silicone resin ELASTOSIL LR3303/20A blended (% by volume) | 20 | 20 | 45 | 10 | 20 | 15 |
| Amount of silicone resin ELASTOSIL LR3303/20B blended (% by volume) | 20 | 20 | 45 | 10 | 20 | 15 |
| Thermal conductivity (W/(m·K)) | 5.1 | Sheet is difficult to obtain | 2.2 | Sheet is difficult to obtain | 5.2 | 5.8 |
| Thickness (mm) | 0.5 | | 0.5 | | 0.5 | 0.5 |

### Industrial Applicability

When the thermally conductive sheet of the present invention is used as a heat-dissipating member for an electronic component, for example, when the thermally conductive sheet is used as a heat-dissipating member in a semiconductor device such as a power device, the electronic component may be used for a long period of time.

## Claims

1. A thermally conductive sheet obtained by dispersing, in a thermosetting resin comprising a silicone resin of addition reaction type, a secondary agglomerated particle obtained by agglomerating primary particles of scale-shaped boron nitride,
wherein the secondary agglomerated particle has an average particle size of 50 µm or more and 120 µm or less, and a porosity of 51% or more and 60% or less, and a particle strength of the secondary agglomerated particle at a cumulative destruction rate of 63.2% is 0.2 MPa or more and 2.0 MPa or less, and a loading rate of the secondary agglomerated particle in the thermally conductive sheet is 50% by volume or more and 70% by volume or less, wherein the particle size, the particle porosity and the particle strength are measured as disclosed in the description.

2. A heat-dissipating member, comprising the thermally conductive sheet according to claim 1.

## Patentansprüche

1. Wärmeleitende Folie, die durch Dispergieren eines agglomerierten Sekundärpartikels, das durch Agglomerieren von Primärpartikeln aus schuppenförmigem Bornitrid erhalten wurde, in einem wärmehärtenden Harz, das ein Silikonharz vom Additionsreaktionstyp umfasst, erhalten wurde,
wobei der agglomerierte Sekundärpartikel eine durchschnittliche Partikelgröße von 50 µm oder mehr und 120 µm oder weniger und eine Porosität von 51 % oder mehr und 60 % oder weniger aufweist und eine Partikelfestigkeit des agglomerierten Sekundärpartikels bei einer kumulativen Zerstörungsrate von 63,2 % 0,2 MPa oder mehr und 2,0 MPa oder weniger beträgt, und eine Beladungsrate des agglomerierten Sekundärpartikels in der wärmeleitenden Folie 50 Volumenprozent oder mehr und 70 Volumenprozent oder weniger beträgt, wobei die Partikelgröße, die Partikelporosität und die Partikelfestigkeit wie in der Beschreibung offenbart gemessen werden.

2. Wärmeableitendes Element, das die wärmeleitende Folie nach Anspruch 1 umfasst.

## Revendications

1. Feuille thermoconductrice obtenue par dispersion, dans une résine thermodurcissable comprenant une résine de silicone de type réaction d'addition, d'une particule secondaire agglomérée obtenue par agglomération de particules primaires de nitrure de bore en forme d'écaille,
dans laquelle la particule secondaire agglomérée a une taille de particule moyenne de 50 µm ou plus et de 120 µm ou moins, et une porosité de 51 % ou plus et de 60 % ou moins, et une résistance de particule secondaire agglomérée à un taux de destruction cumulatif de 63,2 % est de 0,2 MPa ou plus et de 2.0 MPa ou moins, et un taux de charge de la particule secondaire agglomérée dans la feuille thermoconductrice est de 50 % en volume ou plus et de 70 % en volume ou moins, la taille de particule, la porosité de particule et la résistance de particule étant mesurées comme indiqué dans la description.

2. Élément de dissipation de chaleur, comprenant la feuille thermoconductrice selon la revendication 1.
